(19) **Europäisches Patentamt**

**European Patent Office**

**Office européen des brevets**

(11) Veröffentlichungsnummer: **0 471 995 A2**

(12) ## EUROPÄISCHE PATENTANMELDUNG

(21) Anmeldenummer: **91112359.4**

(51) Int. Cl.5: **H05K 7/18**

(22) Anmeldetag: **23.07.91**

(30) Priorität: **21.08.90 DE 9012049 U**

(43) Veröffentlichungstag der Anmeldung:
**26.02.92 Patentblatt 92/09**

(84) Benannte Vertragsstaaten:
**AT DE FR GB IT SE**

(71) Anmelder: **SIEMENS AKTIENGESELLSCHAFT
Wittelsbacherplatz 2
W-8000 München 2(DE)**

(72) Erfinder: **Zell, Karl, Dipl.-Ing.
Moritz-von-Schwind-Weg 80
W-8130 Niederpöcking(DE)**

(54) **Schrank zur Aufnahme von elektrischen Baugruppenträgern.**

(57) Die einzelnen Baugruppenträger erhalten eine Rückwandabdeckung sowie anstelle der üblichen Seitenteile zur Befestigung im Schrank ein umgestaltetes Seitenteil, welches als Außenwand ausgebildet ist und das Stapeln der Baugruppenträger ermöglicht. Der Stapel wird mit einem Boden- und Kopfteil ergänzt.

FIG 1

Die Erfindung betrifft einen Schrank zur Aufnahme von mehreren elektrischen Baugruppenträgern mit unterschiedlichen Baugruppen, die jeweils innerhalb eines Baugruppenträgers über Rückwandsteckerleisten sowie eine Rückwandverdrahtung und mit Baugruppen anderer Baugruppenträger über Steckerkabel verbunden sind, wobei innerhalb der Baugruppenträger unterschiedlich breite Baugruppen einsetzbar sind.

Ein derartiger Schrank ist z. B. aus der DE-OS 28 42 060 bekannt. Bei diesem Schrank sind die Baugruppenträger innerhalb eines Gestellrahmens, der aus senkrechten seitlichen Gestellholmen sowie aus waagerechten oberen und unteren Gestellholmen besteht, angeordnet. Der Nachteil dieses bekannten Schranks besteht darin, daß ein Gestellrahmen bestimmter Größe vorgeleistet werden muß, auch wenn dieser nicht voll bestückt wird. Daher müssen bei diesem bekannten Schrank in der Regel durch die Vorgabe einer bestimmten Schrankgröße unnötig große Vorleistungen erbracht werden.

Aus dem deutschen Gebrauchsmuster 85 09 591 ist nun ein Schrank bekannt, welcher unterschiedlich auftretenden Bestückungswünschen angepaßt werden kann. Dazu besteht dieser Schrank aus mehreren einzelnen selbständigen stapelbaren Baugruppenträgern. Nachteilig bei diesem bekannten Schrank ist, daß je nach Anzahl der verwendeten und übereinander gestapelten Baugruppenträger unterschiedlich große Seitenteile, Rückwände und Türen verwendet werden müssen.

Aufgabe der vorliegenden Erfindung ist es, einen Schrank der eingangs genannten Art anzugeben, welcher bezüglich der unterschiedlich verlangten Größenordnungen beim Aufbau eine noch größere Flexibilität ohne irgendwelche Vorleistungen bietet.

Diese Aufgabe wird für einen Schrank der obengenannten Art erfindungsgemäß dadurch gelöst, daß der Schrank aus einem oder mehreren stapelbaren Baugruppenträgern sowie einem Boden- und einem Kopfteil besteht, daß die einzelnen Baugruppenträger als Außenwand ausgebildete Seitenteile und eine Rückwandabdeckung aufweisen, wobei die Seitenteile an den Unterkanten mit Zapfen und an den Oberkanten mit entsprechenden Aufnahmeöffnungen, die konturmäßig mit den Zapfen übereinstimmen und fluchtend zu den Zapfen angeordnet sind, versehen sind.

Der Vorteil des erfindungsgemäßen Schranks besteht darin, daß Vorleistungen nur für die gewünschte Größe des Schranks geleistet werden müssen, und daß der Schrank anschließend je nach Wunsch beliebig erweiterbar ist, ohne daß bestimmte vorher verwendete Teile nicht mehr benutzt werden können. Durch die Zuordnung der Verkleidungsteile zu den einzelnen stapelbaren Baugruppenträgern werden also unnötige Vorleistungen bei größerer Flexibilität in der Erstellung der Schränke vermieden. Dabei wird die Vorderseite des Schranks durch die Blenden der einzelnen Baugruppen bzw. durch entsprechende Deckblenden gebildet.

Eine zweckmäßige Ausgestaltung des erfindungsgemäßen Schranks ist dadurch gekennzeichnet, daß die Rückwandabdeckung mit Abstand zu den Querholmen der Baugruppenträger angebracht ist. Auf diese Weise kann die Verkabelung des Schranks innerhalb des Schrankraumes erfolgen.

Eine andere zweckmäßige Ausgestaltung des erfindungsgemäßen Schranks ist dadurch gekennzeichnet, daß das Boden- und/oder Kopfteil Lüfter enthalten. Dadurch kann in jeder Ausbaustufe des erfindungsgemäßen Schranks für eine ausreichende Belüftung der einzelnen Baugruppen gesorgt werden.

Nachfolgend wird die Erfindung anhand eines in der Zeichnung dargestellten Ausführungsbeispiels näher erläutert.

Es zeigen

FIG 1    eine perspektivische Ansicht eines Schranks gemäß der vorliegenden Erfindung mit vier übereinander gestapelten Baugruppenträgern sowie eine Kopf- und einem Fußteil,

FIG 2    eine Seitenansicht eines Schranks gemäß der vorliegenden Erfindung mit drei übereinander angeordneten Baugruppenträgern und einem Kopf- sowie einem Fußteil, und

FIG 3    eine perspektivische Teildarstellung eines Baugruppenrahmens eines Schrankes gemäß der vorliegenden Erfindung.

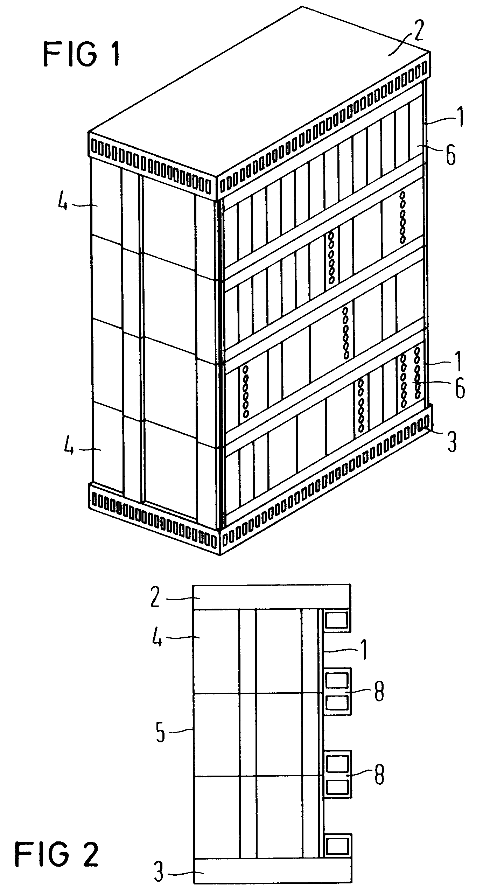

Der Gesamtaufbau eines Schranks, der gemäß der vorliegenden Erfindung aufgebaut ist, ergibt sich aus den FIG 1 und 2. Der Schrank besteht im wesentlichen aus übereinandergestapelten Baugruppenträgern 1. Abgeschlossen wird die Gesamtheit der Baugruppenträger durch ein Kopfteil bzw. durch einen Deckel 2 und ein Fußteil bzw. Bodenteil 3. Die einzelnen Baugruppenträger sind begrenzt von Seitenteilen 4 und Rückwandabdeckungen 5. Den vorderen Abschluß bilden Baugruppenblenden 6, welche je nach Größe der Baugruppen und je nach Aufgabe der Baugruppen unterschiedlich gestaltet sind. Weiterhin können die einzelnen Baugruppenträger 1 an der Vorderseite oben und unten mit Deckblenden 8 versehen sein, hinter denen sich z. B. Baugruppensicherungen gegen unbefugtes Stecken und Ziehen der einzelnen Baugruppen befinden.

Zur besseren Wärmeabfuhr können innerhalb der Bodenteile 3 bzw. der Kopfteile 2 Lüfter integriert werden.

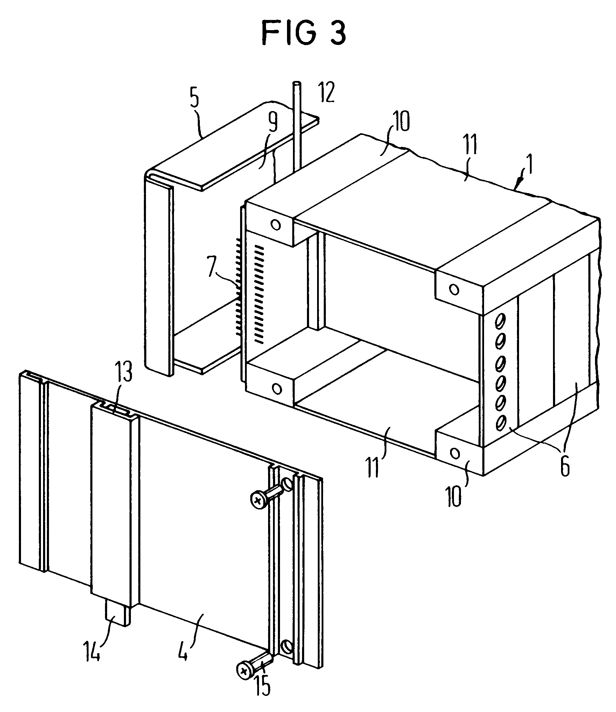

Details eines Baugruppenträgers 1 eines erfindungsgemäßen Schrankes zeigt die FIG 3. Der Baugruppenträger 1 besteht im wesentlichen aus den beiden Seitenteilen 4, die durch Querholme 10 miteinander verbunden sind. Zwischen den oberen und unteren Querholmen 10 eines Baugruppenträgers 1 können unterschiedliche Baugruppen mit entsprechenden Baugruppenblenden 6 eingeschoben werden. Diese Baugruppen werden mittels Steckverbinder mit einer Rückwandverdrahtung 7 kontaktiert. Die Seitenteile, welche gleichzeitig als Schrankverkleidung dienen, weisen an ihren Unterkanten Zapfen 14 auf, die in entsprechende Aufnahmeöffnungen 13, die an ihren Oberkanten angeordnet sind und konturmäßig mit den Zapfen übereinstimmen und mit diesen fluchtend angeordnet sind, eingreifen, und somit ein exaktes Stapeln der Baugruppenträger ermöglichen. Hierbei besteht die Möglichkeit, die Zapfen und die entsprechenden Aufnahmeöffnungen 13 sowie die Schrauben, die zur Befestigung der Seitenteile 4 mit den Querholmen 10 dienen, mittels einer Schraubenverkleidung auf ästhetische Weise zu verkleiden. Die Rückwandabdeckung 5 der einzelnen Baugruppenträger 1 ist mit Abstand von der Rückwandverdrahtung 7 der Baugruppenträger 1 angebracht. Auf diese Weise ist innerhalb des geschlossenen Schrankes eine Verdrahtung der Baugruppen sowie der Baugruppenträger untereinander möglich.

Die einzelnen Baugruppenträger 1 sind oben und unten mittels Schirmblechen 11 abgeschirmt. Um eine 100%ige Schirmung zu erreichen, sind die Baugruppenblenden 6, die Seitenteile 4 sowie die Rückwandabdeckung 5 in das Schirmkonzept integriert.

**Patentansprüche**

1. Schrank zur Aufnahme von mehreren elektrischen Baugruppenträgern mit unterschiedlichen Baugruppen, die jeweils innerhalb eines Baugruppenträgers über Rückwandsteckerleisten sowie eine Rückwandverdrahtung und mit Baugruppen anderer Baugruppenträger über Steckerkabel verbunden sind, wobei innerhalb der Baugruppenträger unterschiedlich breite Baugruppen einsetzbar sind,
**dadurch gekennzeichnet,**
daß der Schrank aus einem oder mehreren stapelbaren Baugruppenträgern (1) sowie einem Boden- (3) und einem Kopfteil (2) besteht, daß die einzelnen Baugruppenträger (1) als Außenwand ausgebildete Seitenteile (4) und eine Rückwandabdeckung (5) aufweisen, wobei die Seitenteile (4) an den Unterkanten mit Zapfen (14) und an den Oberkanten mit entsprechenden Aufnahmeöffnungen (13), die konturmäßig mit den Zapfen (14) übereinstimmen und fluchtend zu den Zapfen (14) angeordnet sind, versehen sind.

2. Schrank nach Anspruch 1,
**dadurch gekennzeichnet,**
daß die Rückwandabdeckung (5) mit Abstand zu den Querholmen (10) der Baugruppenträger (1) angebracht ist.

3. Schrank nach Anspruch 1,
**dadurch gekennzeichnet,**
daß das Boden- (3) und/oder Kopfteil (2) Lüfter enthalten.

FIG 1

4

4

2

1

6

1

6

3

FIG 2

2

4

1

8

5

8

3

# FIG 3